# FASCICULE DE BREVET EUROPEEN

(11) **EP 2 922 063 B1**
(45) Date de publication et mention de la délivrance du brevet: **05.05.2021**
(21) Numéro de dépôt: 15159143.5
(22) Date de dépôt: 16.03.2015
(51) Int. Cl.: G11C 11/412, H01L 27/11

(54) **Structure intégrée comportant des transistors MOS voisins**
Integrierte Struktur, die benachbarte MOS-Transistoren umfasst
Integrated structure comprising neighbouring transistors

(30) Priorité: 21.03.2014 FR 1452363
(43) Date de publication de la demande: 23.09.2015
(73) Titulaire: STMicroelectronics (Rousset) SAS, 13790 Rousset (FR)
(72) Inventeur: Battista, Marc, 13013 Marseille (FR); Tailliet, François, 13710 Fuveau (FR)
(74) Mandataire: Casalonga

(56) Documents cités:
- JP-A- S6 340 361
- US-A- 4 417 325
- US-A- 5 536 671
- US-A1- 2005 161 719
- US-A1- 2009 190 402

## Description

Des modes de réalisation de l'invention concernent des circuits utilisant des transistors MOS voisins ou placés à proximité l'un de l'autre, par exemple en vis-à-vis ou sensiblement en vis-à-vis, avec des régions de grille préférentiellement alignées.

De tels circuits peuvent être par exemple des circuits répétitifs à pas prédéterminés constants, tels que ceux que l'on peut trouver dans des dispositifs de mémoire, par exemple au sein des décodeurs lignes et/ou colonnes, et notamment les dispositifs de mémoire associant au sein d'une même cellule-mémoire, une cellule élémentaire du type mémoire vive statique (SRAM : Static Random Access Memory) et une ou plusieurs cellules-mémoire élémentaires non volatiles, par exemple deux ou quatre, en particulier des cellules-mémoire élémentaires du type mémoire morte électriquement effaçable et programmable (EEPROM : Electrically-Erasable and Programmable Read-Only Memory), à double grille.

En effet, on peut également trouver des transistors MOS placés à proximité l'un de l'autre, dans par exemple les inverseurs de la cellule-mémoire élémentaire de type SRAM.

La distance entre deux transistors MOS voisins est souvent limitée par les contraintes de lithographie imposant des distances minimales entre les deux régions de grille ou encore entre les canaux des deux transistors.

Ces inconvénients s'appliquent également lors de la réalisation de transistors réalisés selon des technologies à double niveau de grille telles que celles que l'on peut retrouver dans des dispositifs de mémoire associant au sein d'une même cellule-mémoire, une cellule élémentaire du type SRAM et une ou plusieurs cellules-mémoire élémentaire(s) non volatile(s), par exemple du type EEPROM, à double grille. Le document US 4 417 325 montre un exemple de cellule-mémoire non volatile à double grille.

Une cellule-mémoire élémentaire du type SRAM est une cellule-mémoire volatile, c'est-à-dire perdant ses données en cas de coupure d'alimentation, mais offrant une rapidité d'accès très rapide ainsi qu'un cyclage infini.

Une cellule-mémoire élémentaire non volatile, par exemple une cellule-mémoire du type EEPROM, permet de conserver la donnée en cas de coupure d'alimentation mais ne peut pas être cyclée indéfiniment.

Une cellule-mémoire associant une cellule élémentaire du type SRAM et une ou plusieurs cellules non volatiles (par exemple deux ou quatre) permet de cumuler les performances des deux approches, à savoir la vitesse et l'endurance infinie de la mémoire SRAM et la non-volatilité de la mémoire non volatile, par exemple la mémoire flash ou EEPROM.

Dans des conditions normales de fonctionnement, l'écriture et la lecture d'une donnée dans une telle cellule-mémoire s'effectuent dans la cellule élémentaire du type SRAM. Par contre, notamment lors d'une coupure d'alimentation, il y a transfert du contenu de la cellule élémentaire SRAM dans la ou les cellules-mémoire élémentaires non volatiles qui lui sont associées.

Puis, lors d'une remontée d'alimentation notamment, il y a rechargement des données contenues dans les cellules-mémoire non volatiles, dans la cellule-mémoire élémentaire SRAM correspondante.

Des exemples d'architectures de telles cellules-mémoire associant mémoire SRAM et mémoire non volatile sont décrites dans les documents US 4,132,905, US 4,467,451, US 4,980,859, US 7,164,608, US 8,018,768 et dans les demandes de brevets français déposées sous les n° 1355439, 1355440 et 1356720.

Lorsque le ou les transistors de la cellule-mémoire élémentaire non volatile sont un ou des transistors à grille flottante, comportant de ce fait deux niveaux de polysilicium par exemple, on réalise avantageusement tous les transistors de la cellule SRAM avec ces deux niveaux de polysilicium.

On effectue alors, en ce qui concerne les transistors de la cellule de type SRAM, un court-circuit entre les deux couches de polysilicium soit par contact électrique, soit par contact physique en supprimant le diélectrique de grille entre les deux couches de polysilicium.

Lors des opérations classiques de gravure, les extrémités des grilles effectives des transistors, c'est-à-dire celles formées par le premier niveau de polysilicium, s'arrondissent, ce qui nécessite alors d'augmenter la taille de ces régions de grille de façon à éviter que ces arrondis soient trop proches de la région de canal, ce qui pourrait engendrer des fuites. Par ailleurs, la géométrie des régions de grille est d'autant plus mal définie que l'empilement de polysilicium à graver est épais. Ces défauts sont parfois corrigés par des corrections optiques de proximité (OPC : « Optical Proximity Correction ») mais ne permettent généralement pas d'obtenir in fine des structures dont les régions de grille présentent des bords bien carrés.

Selon un mode de mise en œuvre et de réalisation, il est proposé de réaliser des transistors voisins présentant une réduction notable de l'espace entre les deux transistors tout en évitant des problèmes de géométrie arrondie au niveau de certaines extrémités des régions de grille gravées.

L'invention est définie par la structure de la revendication 1 et le procédé de fabrication de la revendication 14.

Selon un autre mode de réalisation, il est proposé d'utiliser une telle structure compacte de transistors adjacents dans un dispositif de mémoire, notamment du type associant des cellules-mémoire élémentaires de type SRAM et des cellules-mémoire élémentaires non volatiles de type EEPROM à double grille.

Selon un aspect, il est proposé une structure intégrée comprenant
- une paire de transistors MOS voisins, par exemple en vis-à-vis ou sensiblement en vis-à-vis, chaque transistor comportant une région de grille commandable séparée d'un substrat sous-jacent par un premier diélectrique de grille, par exemple du dioxyde de silicium,
- une région supplémentaire, comportant un matériau de grille, par exemple du polysilicium, séparée des deux régions de grille par un deuxième diélectrique de grille, par exemple un empilement de nitrure de silicium-dioxyde de silicium-nitrure de silicium.

Cette région supplémentaire possède un élément continu situé au-dessus d'une partie des deux régions de grille et une branche solidaire d'une zone de la face inférieure dudit élément et s'étendant entre les et à distance des deux régions de grille jusqu'au premier diélectrique de grille.

On obtient ainsi une structure compacte dont l'espace entre les deux transistors à grilles commandables (c'est-à-dire non flottantes) est réduit par rapport à une structure classique de l'art antérieur.

Même si ce n'est pas indispensable, il est préférable que les deux régions de grille des deux transistors soient alignées, à des fins de simplification de mise en œuvre.

Les projections orthogonales sur le substrat des deux profils en vis-à-vis des deux régions de grille sont avantageusement exemptes d'arrondis, c'est-à-dire présentant des bords carrés.

De façon à pouvoir commander les régions de grille des deux transistors, il est prévu, selon un mode de réalisation, que chaque région de grille déborde dudit élément continu de ladite région supplémentaire, ce qui permet par exemple de prévoir deux plots de contact électriquement conducteurs, situés de part et d'autre de ladite région supplémentaire, et respectivement au contact des deux régions de grille.

Par ailleurs, même si ce n'est pas indispensable, il est avantageux de prévoir un plot de contact supplémentaire au contact de ladite région supplémentaire. En effet, ceci permet éventuellement de laisser cette région supplémentaire flottante, ou bien de la relier à un potentiel, ce qui permet notamment de former à moindre coût, deux condensateurs en parallèle respectivement connectés avec les grilles des deux transistors MOS, l'une des électrodes de chaque condensateur étant formée par la région de grille correspondante.

Et, un tel mode de réalisation trouve une application avantageuse notamment au sein des cellules-mémoire élémentaires du type SRAM associées à des cellules-mémoire élémentaires non volatiles, comme on le verra plus en détail ci-après.

Selon un autre aspect, il est proposé un dispositif de mémoire comprenant un plan-mémoire comportant des lignes et des colonnes de cellules-mémoire du type comportant une cellule-mémoire élémentaire du type SRAM et au moins une cellule-mémoire élémentaire non volatile mutuellement couplées, et des moyens de traitement configurés pour gérer le plan-mémoire.

Selon une caractéristique générale de cet autre aspect, les cellules-mémoire élémentaires non volatiles comportent chacune au moins un transistor à grille flottante et chaque cellule-mémoire élémentaire du type SRAM et/ou les moyens de traitement comportent au moins une structure intégrée telle que définie ci-avant.

On obtient ainsi un dispositif de mémoire présentant un encombrement réduit par rapport à des dispositifs classiques de l'art antérieur.

La cellule-mémoire élémentaire du type SRAM possède généralement deux inverseurs couplés de façon croisée. Et, selon un mode de réalisation, cette cellule-mémoire élémentaire possède au moins une structure intégrée telle que définie ci-avant dont les deux transistors MOS forment respectivement les deux transistors PMOS des deux inverseurs.

Dans la cellule élémentaire de type SRAM, il existe un risque de basculement accidentel des bits, c'est-à-dire une inversion de la valeur logique de la donnée stockée dans la mémoire SRAM au niveau de la bascule formée par les deux inverseurs de cette mémoire. En d'autres termes, si à un instant donné, un niveau logique bas est présent à la sortie de l'un des inverseurs et un niveau logique haut est présent à la sortie de l'autre inverseur, un basculement se traduit par un remplacement du niveau logique haut par le niveau logique bas et inversement, ce qui se traduit par une inversion de la donnée stockée.

Ces erreurs de basculement, encore dénommées par l'homme du métier sont la dénomination anglo-saxonne de « soft errors », peuvent être provoquées par des perturbations causées par des particules telles que des particules alpha ou bien des rayons cosmiques, ou encore par des attaques du dispositif de mémoire par un rayonnement laser.

Une solution actuellement utilisée pour lutter contre ces erreurs de basculement consiste à utiliser des codes correcteurs d'erreurs et à éloigner physiquement des bits appartenant à un même groupe de correction d'erreurs.

Selon un mode de réalisation, il est proposé une solution totalement différente et plus simple pour limiter le risque de basculement accidentel de bits de la cellule SRAM, ce mode de réalisation prévoyant que ladite au moins une structure intégrée est une structure possédant un plot de contact supplémentaire au contact de la région supplémentaire, plot de contact supplémentaire destiné à être connecté à une tension d'alimentation ou à la masse.

En effet, une telle structure, compacte en terme d'encombrement, puisque la première électrode du condensateur est formée par la région de grille du transistor, permet de réaliser de façon simple, une capacité de filtrage au sein de la cellule SRAM, de valeur généralement bien plus élevée que les capacités réalisées au premier niveau de métallisation du circuit intégré, mieux contrôlée et n'induisant pas de couplage avec les interconnexions situées au-dessus de la cellule SRAM.

Cette capacité de filtrage accroît ainsi fortement l'énergie nécessaire pour basculer accidentellement la bascule formée par les deux inverseurs de la cellule SRAM.

Selon un mode de réalisation, les moyens de traitement comprennent un décodeur lignes et un décodeur colonnes qui peuvent avantageusement comporter des structures intégrées telles que définies ci-avant.

A cet égard, le potentiel des régions de grille des deux transistors de la structure peut varier entre 0 volt et une valeur maximum, par exemple 16 volts, et le plot de contact supplémentaire est alors avantageusement destiné à recevoir un potentiel égal à une valeur choisie pour éviter un claquage du deuxième diélectrique de grille, par exemple égale à la moitié de ladite valeur maximale, ici 8 volts.

Selon un autre aspect, il est proposé un circuit intégré incorporant un dispositif de mémoire tel que défini ci-avant.

Selon encore un autre aspect, il est proposé un procédé de réalisation d'une structure intégrée comprenant une paire de transistors MOS voisins.

Ce procédé comprend
- a) une formation au dessus d'un substrat d'un premier diélectrique de grille,
- b) une formation d'une première couche de matériau de grille au dessus du premier diélectrique de grille,
- c) une gravure localisée de la première couche de façon à former une fente rectangulaire dans ladite première couche s'étendant selon une première direction entre deux extrémités,
- d) une formation sur la première couche gravée et sur les flancs de ladite fente d'un deuxième diélectrique de grille,
- e) une formation sur le deuxième diélectrique de grille d'une deuxième couche de matériau de grille,
- f) une gravure de la deuxième couche de matériau de grille, du deuxième diélectrique, de la première couche de matériau de grille et du premier diélectrique, selon un profil possédant une partie rectiligne chevauchant ladite fente entre ses deux extrémités et s'étendant selon une deuxième direction sensiblement orthogonale à la première direction,
de façon à former pour chacun des deux transistors MOS une région de grille commandable séparée du substrat par le premier diélectrique de grille et une région supplémentaire de matériau de grille, séparée des deux régions de grilles par le deuxième diélectrique de grille, et possédant un élément continu situé au-dessus d'une partie des deux régions de grilles et une branche solidaire d'une zone de la face inférieure dudit élément et s'étendant entre les et à distance des deux régions de grilles jusqu'au premier diélectrique de grille.

Selon un mode de mise en œuvre, le procédé comprend après l'étape f) une gravure localisée de la deuxième couche gravée de matériau de grille et du deuxième diélectrique gravé, de façon à faire déborder chaque région de grille dudit élément continu de ladite région supplémentaire, et une formation de plots de contacts électriquement conducteurs sur les deux parties débordantes des deux régions de grilles.

D'autres avantages et caractéristiques de l'invention apparaîtront à l'examen détaillé de modes de mise en œuvre et de réalisation, nullement limitatifs, et des dessins annexés sur lesquels :

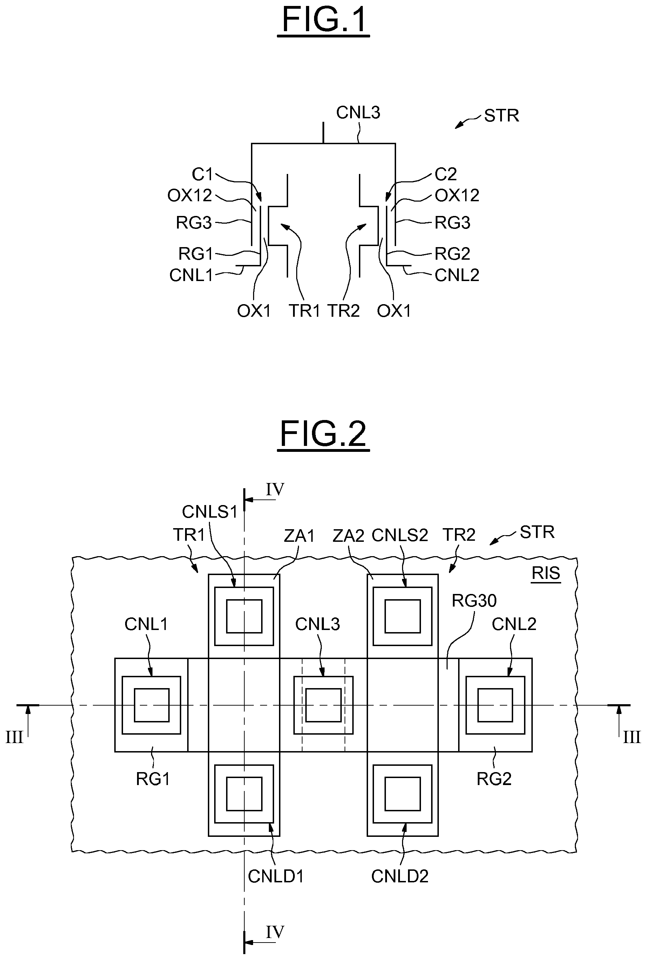

- les figures 1 à 15 illustrent schématiquement différents modes de mise en œuvre et de réalisation de l'invention.

Sur la figure 1, la référence STR désigne le schéma électrique d'une structure intégrée dont un mode de réalisation au sein d'un circuit intégré est illustré schématiquement sur les figures 2 à 5.

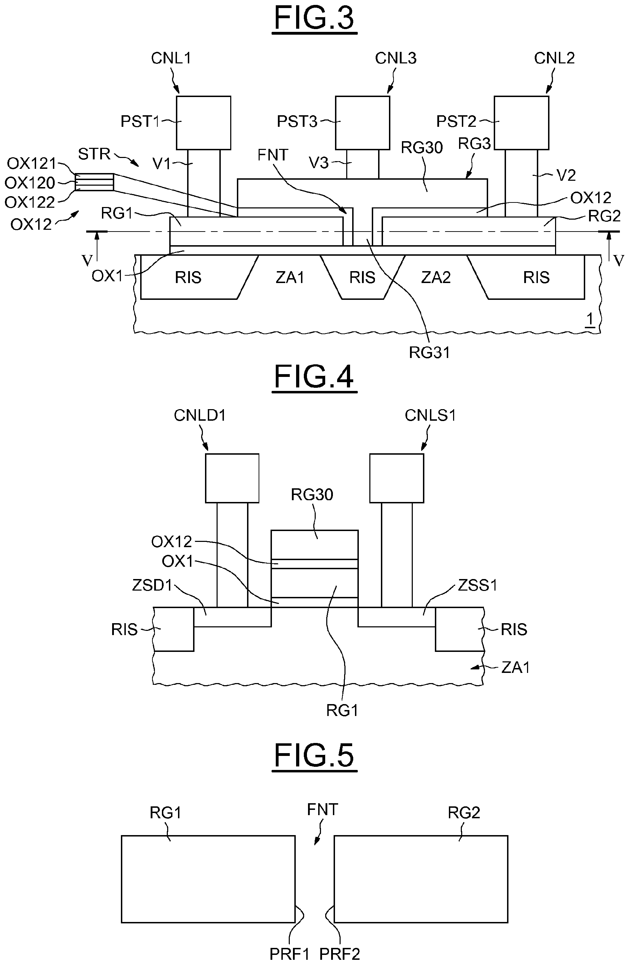

A cet égard, la figure 3 est une section selon la ligne III-III de la figure 2, la figure 4 est une section selon la ligne IV-IV de la figure 2 et la figure 5 est une section partielle selon la ligne V-V de la figure 3.

En se référant à ces figures 1 à 5, on voit que la structure intégrée STR comporte ici une paire de transistors MOS TR1, TR2. Chaque transistor TR1, TR2 comporte une région de grille RG1, RG2 séparée d'un substrat sous-jacent 1 par un premier diélectrique de grille OX1 comportant par exemple du dioxyde de silicium.

Au sein du substrat semiconducteur 1, par exemple en silicium, sont situées les zones actives ZA1 et ZA2 des deux transistors TR1 et TR2 qui sont limitées de façon classique par des régions isolantes RIS, par exemple du type tranchée peu profonde (STI : « Shallow Trench Isolation »).

La structure STR comprend par ailleurs une région supplémentaire RG3 comportant un matériau de grille, qui peut, tout comme pour les régions de grille RG1, contenir du polysilicium.

Cette région supplémentaire RG3 est séparée des deux régions de grille par un deuxième diélectrique de grille OX12 qui, comme illustré sur la figure 3, peut comporter avantageusement un empilement formé d'une couche OX120 de nitrure de silicium Si₃N₄ prise en sandwich entre deux couches OX121 et OX122 de dioxyde de silicium SiO₂.

La région supplémentaire RG3 possède un élément continu RG30 situé au-dessus d'une partie des deux régions de grille RG1 et une branche RG31 solidaire d'une zone de la face inférieure dudit élément RG30 et s'étendant entre les et à distance des deux régions de grille RG1 jusqu'au premier diélectrique de grille OX1.

Les régions de grilles RG1, RG2 débordent ici de l'élément continu RG30, ce qui offre une possibilité aisée de commander ces régions de grilles par application d'un potentiel ou tension de commande.

A cet égard la structure STR comporte par exemple, de part et d'autre de la région supplémentaire RG3, deux plots de contact électriquement conducteurs CNL1, CNL2 respectivement au contact des deux régions de grille RG1, RG2. Ces plots de contact, s'appuyant sur les parties débordantes des régions de grille, permettent de polariser les deux régions de grille RG1 et RG2 et comprennent ici des contacts V1, V2 et des portions de piste métallique PST1, PST2, situées ici au premier niveau de métallisation du circuit intégré.

La structure STR comporte également en outre dans ce mode de réalisation, un plot de contact supplémentaire électriquement conducteur CNL3 au contact de la région supplémentaire RG3 et permettant là encore de polariser éventuellement cette région supplémentaire RG3 avec un potentiel qui peut être la tension d'alimentation ou la masse.

Cela étant, ce plot de contact supplémentaire pourrait être laissé flottant. En variante, on pourrait même éventuellement ne pas prévoir de plot de contact CNL3 si la région supplémentaire RG3 devait effectivement être laissée flottante.

Là encore, le plot de contact CNL3 comporte un contact V3 et une piste métallique PST3, également située ici au premier niveau de métallisation du circuit intégré.

On voit donc, notamment sur les figures 1 et 3, que la région supplémentaire RG3, les deux régions de grille RG1 et RG2 et le deuxième diélectrique de grille OX12 forment deux condensateurs C1 et C2 connectés en parallèle sur les grilles des transistors TR1 et TR2. La première électrode d'un condensateur est la région de grille correspondante du transistor et la deuxième électrode de chaque condensateur est la région supplémentaire RG3.

Les plots de contact CNL1, CNL2 et CNL3 permettent d'appliquer des polarisations différentes sur les électrodes des deux condensateurs.

Sur la figure 4, les zones ZSS1 et ZSD1 désignent respectivement les zones de source et de drain du transistor TR1. Des plots de contact CNLS1, CNLS2, CNLD1 et CNLD2 permettent de polariser les zones de source et de drain des deux transistors TR1 et TR2.

On voit, notamment sur la figure 5 (sur laquelle on n'a pas représenté la branche RG31 à des fins de simplification), que dans ce mode de réalisation, les deux régions de grille RG1 et RG2 sont alignées et sont séparées par une fente FNT. Par ailleurs, les projections orthogonales sur le substrat des deux profils PRF1 et PRF2 des deux régions de grille qui sont en vis-à-vis sont exemptes d'arrondis et comportent des bords carrés.

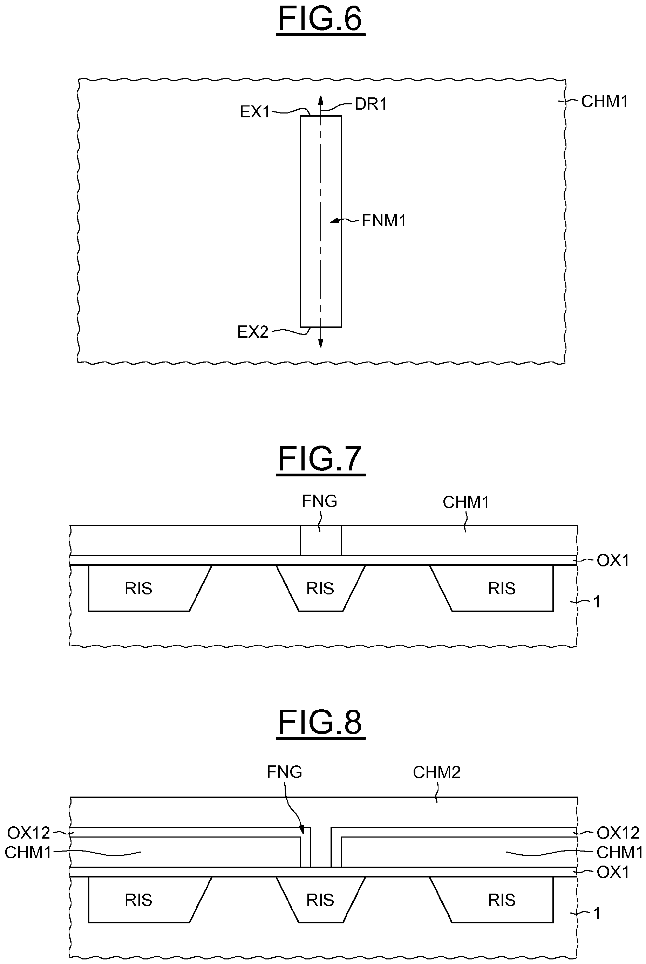

On se réfère maintenant plus particulièrement aux figures 6 à 9 pour décrire un mode de mise en œuvre d'un procédé de réalisation d'une telle structure intégrée STR au sein d'une plaquette semiconductrice (« wafer »).

Après avoir formé de façon classique dans le substrat 1 de la plaquette les zones d'isolation RIS, on forme sur la totalité de la plaquette semiconductrice le premier diélectrique de grille OX1, de façon classique et connue en soi. Puis, on forme, toujours pleine plaque, une première couche CHM1 de matériau de grille, par exemple du polysilicium, au-dessus du premier diélectrique de grille OX1.

On effectue ensuite une gravure localisée de la première couche CHM1 à l'aide d'une étape classique de photolithographie utilisant un masque comportant une fente rectangulaire FNM1 s'étendant selon une première direction DR1 entre deux extrémités EX1 et EX2, de façon à former dans cette première couche CHM1 une fente rectangulaire FNG correspondant à la fente FNM1.

Puis, comme illustré sur la figure 8, on forme, toujours pleine plaque, sur la première couche gravée et sur les flancs de la fente FNG le deuxième diélectrique des grilles OX12.

Puis, on forme, toujours pleine plaque, sur le deuxième diélectrique de grille OX12, une deuxième couche CHM2 de matériau de grille qui vient notamment, comme illustré sur la figure 8, remplir le reste de la fente FNG entre le diélectrique de grille OX12.

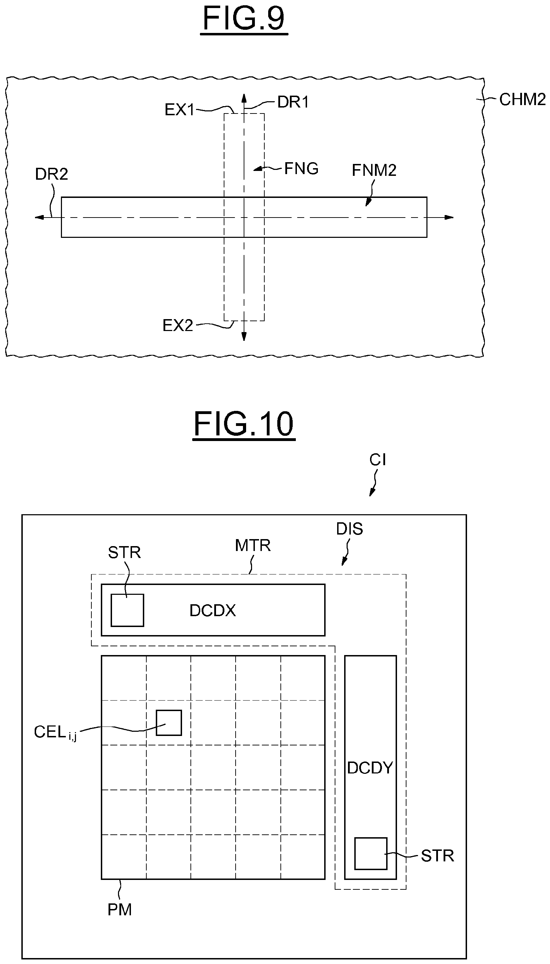

On effectue ensuite, comme illustré sur la figure 9, une gravure de la deuxième couche de matériau de grille CHM2, du deuxième diélectrique OX12, de la première couche de matériau de grille CHM1 et du premier diélectrique OX1, selon un profil FNM2 possédant une partie rectiligne chevauchant ladite fente FNG entre ses deux extrémités EX1, EX2, cette partie rectiligne, ici rectangulaire, s'étendant selon une deuxième direction DR2 sensiblement orthogonale à la première direction.

On obtient alors (après gravure localisée des extrémités de la région RG3 et du deuxième diélectrique de grille OX12 pour permettre les prises de contact des plots de contact CNL1 et CNL2) la structure de double niveau de grille illustrée sur les figures 2 à 5.

Le fait d'avoir utilisé deux géométries orthogonales FNG et FNM2 pour les gravures des couches CHM1 et CHM2 a permis de ne pas créer d'arrondi dans les profils en vis-à-vis des deux régions de grille, comme illustré sur la figure 5. Par ailleurs, le premier masque, comportant la fente FNM1 est associé à une lithographie plus fine que celle associée au masque comportant le profil FNM2. Il en résulte une réduction importante de l'espacement entre les deux transistors. Ainsi, on peut obtenir une réduction supérieure à 50% de l'espace entre les régions actives des deux transistors.

On se réfère maintenant plus particulièrement aux figures 10 à 15 pour illustrer un exemple d'application d'une telle structure intégrée à un dispositif de mémoire DIS incorporé au sein d'un circuit intégré CI.

Comme illustré schématiquement sur la figure 10, le dispositif de mémoire DIS peut comporter en pratique un plan mémoire PM comportant une matrice de cellules CELij organisées en lignes et en colonnes, associé de façon classique à des moyens de traitement (MTR) configurés pour gérer le plan-mémoire PM et comportant notamment un décodeur colonnes DCDX et à un décodeur lignes DCDY.

Les décodeurs lignes et les décodeurs colonnes peuvent comporter des structures intégrées STR telles que décrites ci-avant, ce qui procure un gain de place.

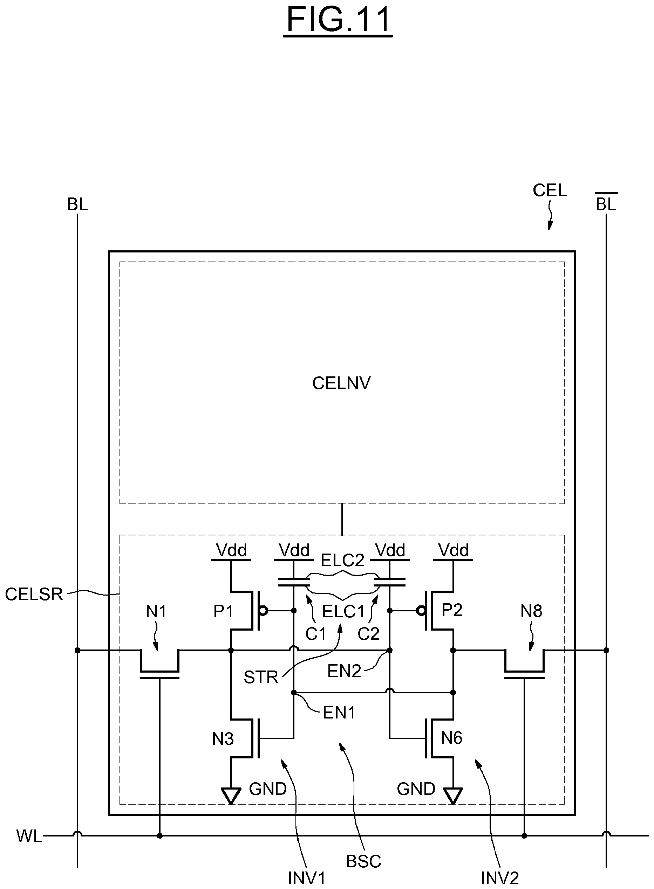

De telles structures STR peuvent être également incorporées au sein des cellules-mémoire CEL_{i,j} du dispositif DIS, comme cela va maintenant être décrit en référence aux figures 11 à 15.

Sur la figure 11, la référence CEL désigne une cellule-mémoire d'un plan mémoire, comportant une cellule-mémoire élémentaire du type SRAM CELSR et au moins une cellule-mémoire élémentaire non volatile CELNV, ces deux cellules-mémoire élémentaires étant mutuellement couplées.

La cellule-mémoire élémentaire CELSR est de structure classique et comprend une bascule BSC formée de deux inverseurs CMOS connectés de façon croisée, ainsi que deux transistors d'accès N1 et N8.

Les deux inverseurs INV1, INV2 sont connectés entre une borne d'alimentation destinée à être connectée à la tension d'alimentation Vdd, et la masse GND.

Les deux transistors d'accès N1 et N8 sont respectivement connectés entre les sorties des deux inverseurs et deux lignes de bits BL et *B̅L̅, B̅L̅* désignant la ligne de bits complémentée de la ligne BL.

Les grilles des transistors d'accès N1 et N8 sont connectées sur une ligne de mots WL.

L'écriture et la lecture d'une donnée dans la cellule-mémoire élémentaire CELSR sont des opérations classiques et connues en soi.

Lors d'une coupure d'alimentation ou sur commande externe, la donnée contenue dans la cellule-mémoire élémentaire CELSR est transférée et stockée dans la cellule-mémoire élémentaire non volatile CELNV. Il s'agit d'un « transfert non volatil ». Puis, lors d'une remontée d'alimentation, la cellule-mémoire élémentaire CELSR est rechargée avec le contenu de la cellule-mémoire élémentaire non volatile CELNV.

Et, selon les configurations choisies lors de cette opération de rechargement de la cellule CELSR, la donnée peut ou non être inversée par rapport à celle qui était initialement stockée dans la cellule-mémoire CELSR avant le transfert non volatil vers la cellule-mémoire élémentaire non volatile CELNV.

La cellule-mémoire élémentaire CELSR de la cellule de la figure 11 est configurée pour réduire le risque de basculement accidentel des états logiques présents aux nœuds de sortie des deux inverseurs, par exemple en présence de rayons cosmiques ou encore lors d'une attaque par faisceau laser.

A cet égard, la cellule CELSR comporte une structure STR du type de celles illustrées sur les figures 1 à 5 et formant les deux transistors PMOS P1 et P2 des deux inverseurs INV1 et INV2.

Par ailleurs, alors que, comme indiqué ci-avant, les premières électrodes ELC1 de ces deux condensateurs C1 et C2 sont respectivement formées par les grilles des transistors P1 et P2, les deuxièmes électrodes ELC2 de ces deux condensateurs C1 et C2 sont ici reliées aux sources de ces deux transistors P1 et P2, et donc à la tension d'alimentation Vdd.

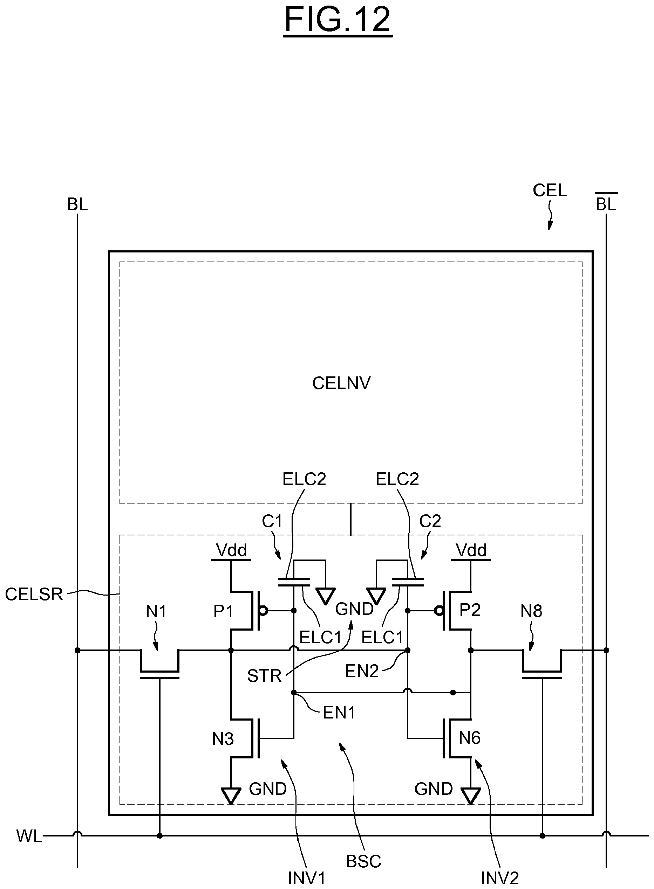

Il serait possible, en variante, comme illustré sur la figure 12, de relier les deux électrodes ELC2 des deux condensateurs C1 et C2 à la masse GND.

Ces deux condensateurs C1 et C2 permettent d'augmenter la capacité totale de la bascule BSC ce qui accroît l'énergie nécessaire pour faire basculer accidentellement la bascule BSC.

L'épaisseur du premier diélectrique de grille OX1 (figure 3) est typiquement comprise entre 20 Å et 250 Å tandis que l'épaisseur du deuxième diélectrique de grille OX12 est typiquement comprise entre 100 Å et 200 Å. Le fait d'avoir pour le diélectrique OX12 un sandwich SiO₂-Si₃N₄-SiO₂ permet d'obtenir une capacité bien contrôlée.

Il convient de noter que l'utilisation d'une structure STR pour réaliser les transistors PMOS des inverseurs permet un gain de place, que la région RG3 soit laissée flottante ou soit reliée à un potentiel.

Il aurait été également possible de réaliser les deux transistors NMOS M3 et M6 des deux inverseurs au moyen d'une autre structure STR. Cela étant, étant donné que ces deux transistors M3 et M6 sont sur le schéma de placement (« layout ») décalés, il a été préférable, pour des raisons de simplicité de mise en œuvre, de ne pas utiliser de structure STR pour ces transistors NMOS.

L'invention s'applique à tout type de cellule-mémoire non volatile ayant un ou plusieurs transistors à grille flottante, comme par exemple des cellules EEPROM.

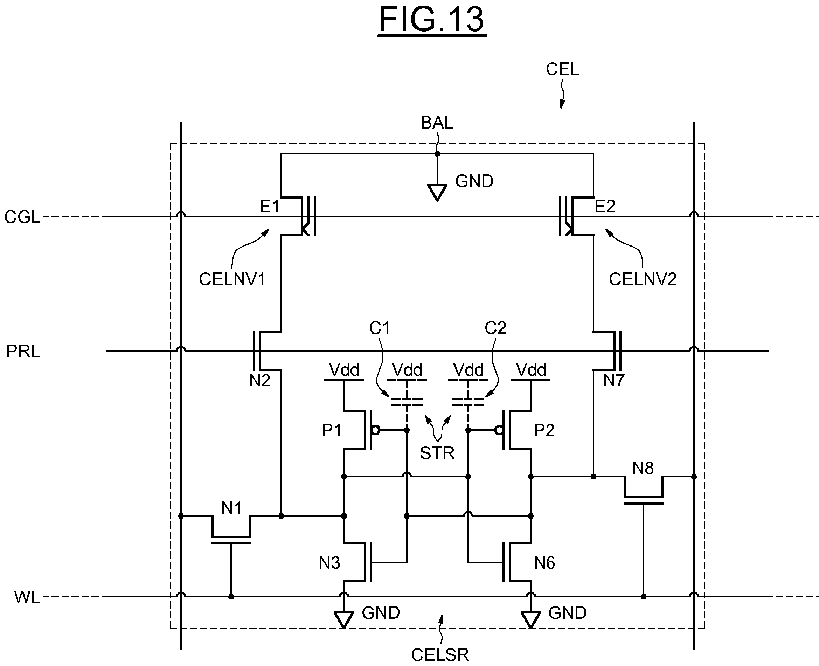

La figure 13 illustre un exemple de réalisation d'une cellule-mémoire CEL comportant la cellule-mémoire élémentaire du type SRAM CELSR et deux cellules élémentaires non volatiles du type EEPROM CELNV1 et CELNV2 comportant ici deux transistors à grille flottante El et E2.

Une telle cellule a été décrite dans la demande de brevet français n° 1356720. On en rappelle maintenant certaines caractéristiques.

Les cellules non volatiles EEPROM de la cellule CEL sont des cellules classiques c'est-à-dire dans lesquelles on a retiré le transistor de sélection et présentant une zone d'injection tunnel entre grille flottante et drain.

Les sources de ces deux transistors E1 et E2 sont reliées à une borne d'alimentation BAL qui est ici reliée à la masse.

Les électrodes de commande des deux transistors à grille flottante E1 et E2 sont quant à elles connectées sur une première ligne de commande CGL.

Les drains des deux transistors à grille flottante E1 et E2 sont connectés aux entrées et aux sorties des deux inverseurs de la cellule CELSR par un étage d'interconnexion comportant ici deux transistors d'interconnexion NMOS référencés N2 et N7.

Plus précisément, les deux transistors d'interconnexion N2 et N7 sont respectivement connectés entre les drains des deux transistors à grille flottante E1 et E2 et les deux sorties des deux inverseurs P1, N3 et P2, N6. Par ailleurs, les électrodes de commande (grilles) de ces deux transistors d'interconnexion N2 et N7 sont connectées sur une deuxième ligne de commande PRL.

Lors de l'écriture dans la cellule-mémoire élémentaire CELSR, qui est une écriture classique, la ligne de commande PRL est à la masse rendant bloqué l'étage d'interconnexion. De même, la première ligne de commande CGL est également à la masse.

Comme il est bien connu par l'homme du métier, un transfert ou écriture non volatil se compose d'un cycle d'effacement suivi d'un cycle de programmation différentiel puisqu'on est en présence de deux cellules-mémoire élémentaires non volatiles.

Pour le cycle d'effacement, la ligne PRL est maintenue à la masse rendant bloqués les transistors d'interconnexion N2 et N7. On envoie ensuite une tension d'effacement sur la première ligne de commande CGL.

Pendant le cycle de programmation différentielle, la deuxième ligne de commande PRL passe à la tension d'alimentation rendant passants les transistors N2 et N7. On envoie ensuite une tension de programmation pour la première ligne de commande CGL.

Pour un rechargement de la cellule CELSR, la première ligne de commande CGL passe à une tension de référence de lecture, typiquement 1 volt, tandis que la deuxième ligne de commande PRL est à une tension de 2 volts par exemple de façon à rendre passants les transistors N2 et N7.

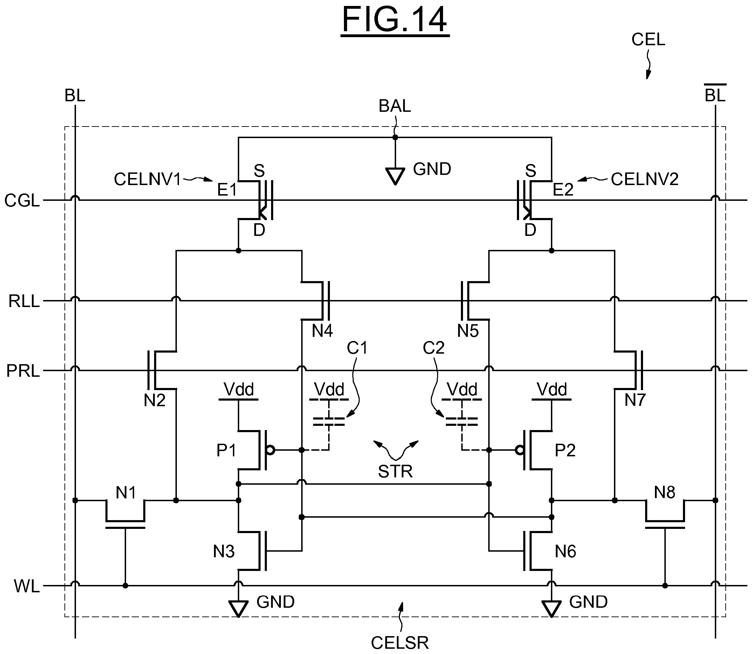

La figure 14 illustre un autre mode de réalisation d'une cellule-mémoire CEL incorporant là encore deux cellules-mémoire non volatiles du type EEPROM CELNV1 et CELNV2 comportant ici deux transistors à grille flottante El et E2.

Une telle cellule a été décrite dans la demande de brevet n° 1355439. On en rappelle ici certaines caractéristiques.

Là encore, les cellules non volatiles EEPROM de la cellule CEL sont des cellules classiques c'est-à-dire dans lesquelles on a retiré le transistor de sélection et présentant une zone d'injection tunnel entre grille flottante et drain.

Les sources de ces deux transistors E1 et E2 sont reliées à une borne d'alimentation BAL qui est ici reliée à la masse.

Les électrodes de commande des deux transistors à grille flottante E1 et E2 sont quant à elles connectées sur une première ligne de commande CGL.

Les drains des deux transistors à grille flottante E1 et E2 sont connectés aux entrées et aux sorties des deux inverseurs par un étage d'interconnexion comportant ici deux premiers transistors d'interconnexion NMOS référencés N2 et N7 et deux deuxièmes transistors d'interconnexion NMOS référencés N4 et N5.

Plus précisément, les deux premiers transistors d'interconnexion N2 et N7 sont respectivement connectés entre les drains des deux transistors à grille flottante E1 et E2 et les deux sorties des deux inverseurs P1, N3 et P2, N6. Par ailleurs, les électrodes de commande (grilles) de ces deux transistors d'interconnexion N2 et N7 sont connectées sur une deuxième ligne de commande PRL.

Les deux deuxièmes transistors d'interconnexion N4 et N5 sont quant à eux respectivement connectés entre les drains des deux transistors à grille flottante E1 et E2 et les deux entrées de deux inverseurs P1, N3 et P2, N6.

Les électrodes de commande de ces deux deuxièmes transistors d'interconnexion N4 et N5 sont connectées sur une troisième ligne de commande RLL.

Bien que les deux deuxièmes transistors d'interconnexion N4 et N5 ne soient pas indispensables, ils sont particulièrement avantageux car ils permettent d'éviter une inversion de données lors du rechargement du contenu des deux cellules non volatiles E1 et E2 vers la cellule-mémoire élémentaire SRAM CELSR et ce, même avec une borne d'alimentation BAL reliée à la masse.

L'écriture dans la cellule mémoire élémentaire CELSR est une écriture classique.

Les lignes de commande PRL, RLL sont à cet égard à la masse, rendant bloqué l'étage d'interconnexion. De même, la première ligne de commande CGL est également à la masse.

La lecture d'une donnée dans la cellule CELSR est également une lecture classique.

Pour le cycle d'effacement, les lignes PRL et PLL sont maintenues à la masse, rendant bloqués les transistors d'interconnexion N2, N4, N5 et N7. On envoie ensuite une tension d'effacement sur la première ligne de commande CGL.

Pour le cycle de programmation différentielle, la deuxième ligne de commande PRL passe à la tension d'alimentation Vdd tandis que la troisième ligne de commande RLL reste à la masse.

De ce fait, les transistors d'interconnexion N2 et N7 sont passants tandis que les transistors d'interconnexion N4 et N5 sont bloqués.

On envoie ensuite une tension de programmation sur la première ligne de commande CGL.

Les transistors à grille flottante E1 et E2 sont tous bloqués lors de cette programmation différentielle.

Pour un rechargement de la cellule CELSR, la première ligne de commande CGL passe à une tension de référence de lecture, typiquement 1 volt, tandis que la deuxième ligne de commande PRL est à la masse et que la troisième ligne de commande RLL est à une tension de 2 volts par exemple de façon à rendre passants les transistors N4 et N5 tandis que les transistors N2 et N7 sont bloqués.

La tension de la ligne de mots WL est nulle.

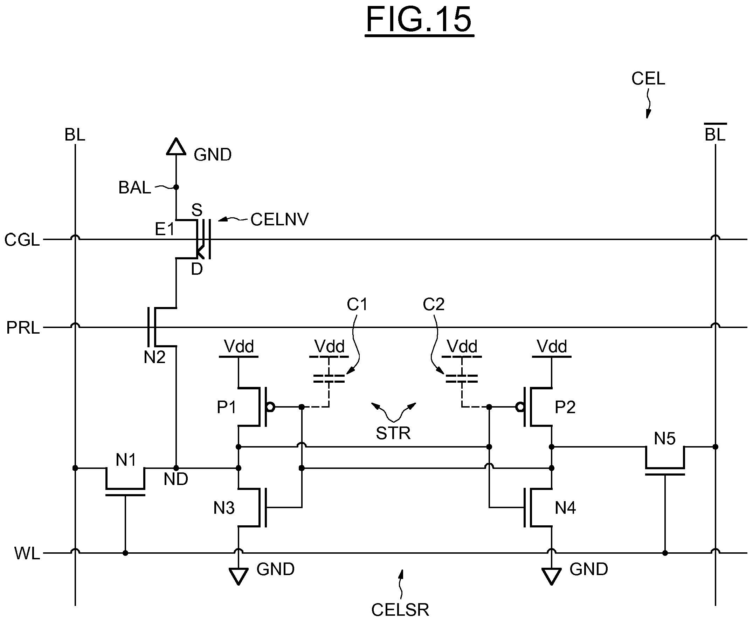

La figure 15 illustre encore un autre mode de réalisation d'une cellule-mémoire CEL.

Une telle cellule a été décrite sur la demande de brevet français précité n° 1355440.

On en rappelle ici certaines caractéristiques.

Cette cellule-mémoire CEL comporte une unique cellule élémentaire non volatile du type EEPROM CELNV comportant ici un transistor à grille flottante El commandable de façon à être bloqué lors d'une programmation dans la cellule-mémoire élémentaire non volatile, d'une donnée stockée dans la cellule-mémoire élémentaire du type SRAM.

Là encore, la cellule non volatile EEPROM de la cellule CEL est une cellule classique c'est-à-dire dans laquelle on a retiré le transistor de sélection et présentant une zone d'injection tunnel entre grille flottante et drain.

La source du transistor El est reliée à une borne d'alimentation BAL qui est ici reliée à la masse.

L'électrode de commande du transistor à grille flottante El est quant à elle connectée sur une première ligne de commande CGL.

Le drain du transistor à grille flottante El est connecté ici à la sortie (nœud ND) du premier inverseur P1, N3 de la cellule-mémoire élémentaire CELSR par l'intermédiaire d'un étage d'interconnexion comportant ici un premier transistor d'interconnexion N2. Cet unique transistor d'interconnexion N2 est ici un transistor NMOS.

L'électrode de commande (grille) de ce premier transistor d'interconnexion N2 est connectée sur une deuxième ligne de commande PRL. De ce fait l'étage d'interconnexion est commandé par un signal externe à la cellule-mémoire CEL, à savoir par la tension de commande présente sur la deuxième ligne de commande PRL.

L'écriture dans la cellule mémoire élémentaire CELSR est là encore une écriture classique.

La ligne de commande PRL est à cet égard à la masse, rendant bloqué l'étage d'interconnexion. De même, la première ligne de commande CGL est également à la masse.

Pour le cycle d'effacement, la ligne PRL est maintenue à la masse, rendant bloqué le transistor d'interconnexion N2. On envoie ensuite une tension d'effacement sur la première ligne de commande CGL.

Pour le cycle de programmation la deuxième ligne de commande PRL passe à la tension d'alimentation Vdd

De ce fait, le transistor d'interconnexion N2 est passant.

On envoie ensuite une tension de programmation sur la première ligne de commande CGL.

Préalablement à un rechargement, on effectue une initialisation (ou une réinitialisation) de la cellule-mémoire élémentaire SRAM CELSR de façon à l'initialiser dans un état connu et éviter qu'elle soit dans un état métastable.

Cette initialisation peut s'effectuer par exemple par écriture d'un « 1 » dans la cellule SRAM en utilisant la procédure d'écriture classique.

Pour le rechargement, la première ligne de commande CGL passe à une tension de référence de lecture, typiquement 1 volt, tandis que la deuxième ligne de commande PRL est à une tension de 2 volts par exemple de façon à rendre passant le transistor d'interconnexion N2.

La tension de la ligne de mots WL est nulle.

## Revendications

1. Structure intégrée comprenant une paire de transistors MOS (TR1, TR2) voisins, chaque transistor (TR1, TR2) comportant une région de grille (RG1, RG2) commandable séparée d'un substrat sous-jacent (1) par un premier diélectrique de grille (OX1), une région supplémentaire (RG3), comportant un matériau de grille, séparée des deux régions de grilles (RG1, RG2) par un deuxième diélectrique de grille (OX12), et possédant un élément continu (RG30) situé au-dessus d'une partie des deux régions de grilles et une branche (RG31) solidaire d'une zone de la face inférieure dudit élément et s'étendant entre les et à distance des deux régions de grilles jusqu'au premier diélectrique de grille,
**caractérisée en ce que** chaque région de grille (RG1, RG2) déborde dudit élément continu (RG30) de ladite région supplémentaire (RG3), la structure comprenant en outre de part et d'autre de ladite région supplémentaire deux plots de contacts électriquement conducteurs (CNL1, CNL2) respectivement au contact des deux régions de grille.

2. Structure selon la revendication 1, dans laquelle les deux régions de grilles (RG1, RG2) sont alignées.

3. Structure selon l'une des revendications précédentes, dans laquelle les projections orthogonales sur le substrat des deux profils (PRF1, PRF2) en vis-à-vis des deux régions de grille sont exemptes d'arrondis.

4. Structure selon l'une des revendications précédentes, dans laquelle le deuxième diélectrique de grille (O12) comprend une couche de nitrure de silicium (OX120) prise en sandwich entre deux couches de dioxyde de silicium (OX121, OX122).

5. Structure selon l'une des revendications précédentes, dans laquelle les matériaux formant les deux régions de grille (RG1, RG2) et la région supplémentaire (RG3) comportent du polysilicium.

6. Structure selon l'une des revendications précédentes, comprenant en outre un plot de contact supplémentaire électriquement conducteur (CNL3) au contact de ladite région supplémentaire.

7. Dispositif de mémoire comprenant un plan-mémoire comportant des lignes et des colonnes de cellules-mémoire (CELi,j) du type comportant une cellule-mémoire élémentaire du type SRAM (CELSR) possédant deux inverseurs couplés de façon croisée et au moins une cellule-mémoire élémentaire non volatile (CELNV) mutuellement couplées, et des moyens de traitement (MTR) configurés pour gérer le plan-mémoire, **caractérisé en ce que** les cellules-mémoire élémentaires non volatiles comportent chacune au moins un transistor à grille flottante (El), et chaque cellule-mémoire élémentaire du type SRAM (CELSR) et/ou les moyens de traitement (MTR) comportent au moins une structure intégrée (STR) selon l'une des revendications 1 à 6.

8. Dispositif selon la revendication 7, dans lequel chaque cellule-mémoire élémentaire du type SRAM possède au moins une structure intégrée (STR) dont les deux transistors MOS forment respectivement les deux transistors PMOS (P1, P2) des deux inverseurs.

9. Dispositif selon la revendication 8, dans lequel ladite au moins une structure intégrée est une structure (STR) selon la revendication 6 dans laquelle le plot de contact supplémentaire (CNL3) est destiné à être connecté à une tension d'alimentation (Vdd) ou à la masse (GND).

10. Dispositif selon la revendication 7, dans lequel les moyens de traitement (MTR) comprennent un décodeur lignes (DCDY) et un décodeur colonnes (DCDX) comportant des structures intégrées (STR) selon l'une des revendications 1 à 6.

11. Dispositif selon l'une des revendications 7 à 10, dans lequel ladite au moins une cellule-mémoire comprend une unique cellule-mémoire élémentaire non volatile (E1) connectée entre une borne d'alimentation (BAL) et la cellule-mémoire élémentaire du type SRAM (CELSR), le transistor à grille flottante (E1) de la cellule-mémoire élémentaire non volatile étant commandable de façon à être bloqué lors d'une programmation dans la cellule-mémoire élémentaire non volatile (El), d'une donnée stockée dans la cellule-mémoire élémentaire du type SRAM (CELSR).

12. Dispositif selon l'une des revendications 7 à 10, dans lequel ladite au moins une cellule-mémoire comprend deux groupes (E1, E2) comportant chacun au moins une cellule-mémoire élémentaire non volatile possédant un transistor à grille flottante, tous les transistors à grille flottante ayant leur première électrode de conduction connectée à une borne d'alimentation (BAL) et leur électrode de commande connectée à une première ligne de commande (CGL), les deuxièmes électrodes de conduction des transistors à grille flottante des cellules mémoire élémentaires non volatile des deux groupes étant respectivement connectées au moins aux sorties des deux inverseurs par l'intermédiaire d'un étage d'interconnexion commandable (N2, N4, N5, N7), les transistors à grille flottante (E1, E2) étant commandables de façon à être tous bloqués lors d'une programmation différentielle dans les deux groupes de cellules-mémoire élémentaires non volatiles, d'une donnée stockée dans la cellule-mémoire élémentaire du type SRAM.

13. Circuit intégré comprenant un dispositif de mémoire selon l'une des revendications 7 à 12.

14. Procédé de réalisation d'une structure intégrée comprenant une paire de transistors MOS voisins, le procédé comprenant
a) une formation au dessus d'un substrat (1) d'un premier diélectrique de grille (OX1),
b) une formation d'une première couche de matériau de grille (CHM1) au dessus du premier diélectrique de grille,
c) une gravure localisée de la première couche de façon à former une fente rectangulaire (FNG) dans ladite première couche s'étendant selon une première direction (DR1) entre deux extrémités,
d) une formation sur la première couche gravée et sur les flancs de ladite fente d'un deuxième diélectrique de grille (OX12),
e) une formation sur le deuxième diélectrique de grille d'une deuxième couche de matériau de grille (CHM2),
f) une gravure de la deuxième couche de matériau de grille, du deuxième diélectrique, de la première couche de matériau de grille et du premier diélectrique, selon un profil (FNM2) possédant une partie rectiligne chevauchant ladite fente entre ses deux extrémités et s'étendant selon une deuxième direction sensiblement orthogonale à la première direction,
**caractérisé en ce qu'**il comprend en outre après l'étape f), une gravure localisée de la deuxième couche gravée de matériau de grille et du deuxième diélectrique gravé, de façon à faire déborder chaque région de grille dudit élément continu (RG30) de ladite région supplémentaire (RG3), et une formation de plots de contacts électriquement conducteurs (CNL1, CNL2) sur les deux parties débordantes des deux régions de grilles.
de façon à former pour chacun des deux transistors MOS une région de grille commandable séparée d'une zone sous jacente de substrat par le premier diélectrique de grille et une région supplémentaire de matériau de grille, séparée des deux régions de grilles par le deuxième diélectrique de grille, et possédant un élément continu situé au-dessus d'une partie des deux régions de grilles et une branche solidaire d'une zone de la face inférieure dudit élément et s'étendant entre les et à distance des deux régions de grilles jusqu'au premier diélectrique de grille.

## Patentansprüche

1. Integrierte Struktur, umfassend ein Paar von benachbarten MOS-Transistoren (TR1, TR2), wobei jeder Transistor (TR1, TR2) eine steuerbare Gate-Region (RG1, RG2), die durch ein erstes Gate-Dielektrikum (OX1) von einem darunterliegenden Substrat (1) getrennt ist, und eine zusätzliche Region (RG3) umfasst, umfassend ein Gate-Material, die zwei Gate-Regionen (RG1, RG2) durch ein zweites Gate-Dielektrikum (OX12) trennt, und aufweisend ein kontinuierliches Element (RG30), das sich über einem Teil von zwei Gate-Regionen befindet, und einen Zweig (RG31), der fest mit einer Zone der Innenseite des Elements verbunden ist und sich zwischen den zwei Gate-Regionen und in einem Abstand von diesen bis zu dem ersten Gate-Dielektrikum erstreckt,
**dadurch gekennzeichnet, dass** jede Gate-Region (RG1, RG2) über das kontinuierliche Element (RG30) der zusätzlichen Region (RG3) hinausragt, wobei die Struktur weiterhin zu beiden Seiten der zusätzlichen Region zwei elektrisch leitende Kontaktpads (CNL1, CNL2) jeweils in Kontakt mit zwei Gate-Regionen umfasst.

2. Struktur nach Anspruch 1, wobei die zwei Gate-Regionen (RG1, RG2) aufeinander ausgerichtet sind.

3. Struktur nach einem der vorhergehenden Ansprüche, wobei die Orthogonalprojektionen auf das Substrat von zwei gegenüberliegenden Profilen (PRF1, PRF2) von zwei Gate-Regionen frei von Rundungen sind.

4. Struktur nach einem der vorhergehenden Ansprüche, wobei das zweite Gate-Dielektrikum (012) eine Siliciumnitridschicht (OX120) umfasst, die zwischen zwei Siliciumdioxidschichten (OX121, OX122) eingeschoben ist.

5. Struktur nach einem der vorhergehenden Ansprüche, wobei die Materialien, die die zwei Gate-Regionen (RG1, RG2) und die zusätzliche Region (RG3) bilden, Polysilicium umfassen.

6. Struktur nach einem der vorhergehenden Ansprüche, weiterhin umfassend ein zusätzliches elektrisch leitendes Kontaktpad (CNL3) in Kontakt mit der zusätzlichen Region.

7. Speichervorrichtung, umfassend eine Speicherebene, umfassend Zeilen und Spalten von Speicherzellen (CEL_{i,j}) des Typs, umfassend eine Elementarspeicherzelle vom SRAM-Typ (CELSR), aufweisend zwei kreuzgekoppelte Wechselrichter, und mindestens eine nichtflüchtige Elementarspeicherzelle (CELNV), die miteinander gekoppelt sind, und Verarbeitungsmittel (MTR), die zum Verwalten der Speicherebene konfiguriert sind, **dadurch gekennzeichnet, dass** die nichtflüchtigen Elementarspeicherzellen jeweils mindestens einen Floating-Gate-Transistor (E1) umfassen und jede Elementarspeicherzelle vom SRAM-Typ (CELSR) und/oder die Verarbeitungsmittel (MTR) mindestens eine integrierte Struktur (STR) nach einem der Ansprüche 1 bis 6 umfassen.

8. Vorrichtung nach Anspruch 7, wobei jede Elementarspeicherzelle vom SRAM-Typ mindestens eine integrierte Struktur (STR) aufweist, in der die zwei MOS-Transistoren jeweils die zwei PMOS-Transistoren (P1, P2) von zwei Wechselrichtern bilden.

9. Vorrichtung nach Anspruch 8, wobei die mindestens eine integrierte Struktur eine Struktur (STR) nach Anspruch 6 ist, wobei das zusätzliche Kontaktpad (CNL3) dazu vorgesehen ist, mit einer Versorgungsspannung (Vdd) oder mit der Masse (GND) verbunden zu werden.

10. Vorrichtung nach Anspruch 7, wobei die Verarbeitungsmittel (MTR) einen Zeilendecoder (DCDY) und einen Spaltendecoder (DCDX) umfassen, umfassend integrierte Strukturen (STR) nach einem der Ansprüche 1 bis 6.

11. Vorrichtung nach einem der Ansprüche 7 bis 10, wobei die mindestens eine Speicherzelle eine einzige nichtflüchtige Elementarspeicherzelle (E1) umfasst, die zwischen einer Zuleitungsklemme (BAL) und der Elementarspeicherzelle vom SRAM-Typ (CELSR) angeschlossen ist, wobei der Floating-Gate-Transistor (E1) der nichtflüchtigen Elementarspeicherzelle steuerbar ist, um während einer Programmierung eines Datensatzes, der in der Elementarspeicherzelle vom SRAM-Typ (CELSR) gespeichert ist, in die nichtflüchtige Elementarspeicherzelle (E1) blockiert zu werden.

12. Vorrichtung nach einem der Ansprüche 7 bis 10, wobei die mindestens eine Speicherzelle zwei Gruppen (E1, E2) umfasst, die jeweils mindestens eine nichtflüchtige Elementarspeicherzelle, aufweisend einen Floating-Gate-Transistor, umfassen, wobei alle Floating-Gate-Transistoren ihre erste Leitelektrode mit einer Zuleitungsklemme (BAL) verbunden und ihre Steuerelektrode mit einer ersten Steuerleitung (CGL) verbunden aufweisen, wobei die zweiten Leitelektroden von Floating-Gate-Transistoren von nichtflüchtigen Elementarspeicherzellen von zwei Gruppen jeweils mittels einer steuerbaren Zusammenschaltungsstufe (N2, N4, N5, N7) mindestens mit Ausgängen von zwei Wechselrichtern verbunden sind, wobei die Floating-Gate-Transistoren (E1, E2) steuerbar sind, um alle während einer differentiellen Programmierung eines Datensatzes, der in der Elementarspeicherzelle vom SRAM-Typ gespeichert ist, in die zwei Gruppen von nichtflüchtigen Elementarspeicherzellen blockiert zu werden.

13. Integrierte Schaltung, umfassend eine Speichervorrichtung nach einem der Ansprüche 7 bis 12.

14. Verfahren zur Herstellung einer integrierten Struktur, umfassend ein Paar von benachbarten MOS-Transistoren, wobei das Verfahren umfasst:
a) ein Bilden eines ersten Gate-Dielektrikums (OX1) über einem Substrat (1),
b) ein Bilden einer ersten Gate-Material-Schicht (CHM1) über dem ersten Gate-Dielektrikum,
c) ein lokalisiertes Ätzen der ersten Schicht, um einen rechteckigen Schlitz (FNG) in der ersten Schicht zu bilden, die sich gemäß einer ersten Richtung (DR1) zwischen zwei Enden erstreckt,
d) ein Bilden eines zweiten Gate-Dielektrikums (OX12) auf der geätzten ersten Schicht und auf den Seiten des Schlitzes,
e) ein Bilden einer zweiten Gate-Material-Schicht (CHM2) auf dem zweiten Gate-Dielektrikum,
f) ein Ätzen der zweiten Gate-Material-Schicht, des zweiten Dielektrikums, der ersten Gate-Material-Schicht und des ersten Dielektrikums gemäß einem Profil (FNM2), aufweisend einen geradlinigen Teil, der den Schlitz zwischen seinen zwei Enden überlappt und sich gemäß einer zweiten Richtung erstreckt, die im Wesentlichen orthogonal zu der ersten Richtung ist,
**dadurch gekennzeichnet, dass** es weiterhin nach dem Schritt f) ein lokalisiertes Ätzen der geätzten zweiten Gate-Material-Schicht und des geätzten zweiten Dielektrikums, um über jede Gate-Region des kontinuierlichen Elements (RG30) der zusätzlichen Region (RG3) hinauszuragen, und ein Bilden von elektrisch leitenden Kontaktpads (CNL1, CNL2) auf den zwei hinausragenden Teilen von zwei Gate-Regionen umfasst,
um für jeden von zwei MOS-Transistoren eine steuerbare Gate-Region, die durch das erste Gate-Dielektrikum von einer darunterliegenden Substratzone getrennt ist, und eine zusätzliche Gate-Material-Region zu bilden, die zwei Gate-Regionen durch das zweite Gate-Dielektrikum trennt, und aufweisend ein kontinuierliches Element, das sich über einem Teil von zwei Gate-Regionen befindet, und einen Zweig, der fest mit einer Zone der Innenseite des Elements verbunden ist und sich zwischen den zwei Gate-Regionen und in einem Abstand von diesen bis zu dem ersten Gate-Dielektrikum erstreckt.

## Claims

1. Integrated structure comprising a pair of neighbouring MOS transistors (TR1, TR2), each transistor (TR1, TR2) including a controllable gate region (RG1, RG2) separated from an underlying substrate (1) by a first gate dielectric (OX1), an additional region (RG3), including a gate material, separated from the two gate regions (RG1, RG2) by a second gate dielectric (OX12), and having a continuous element (RG30) located on top of a part of the two gate regions and a branch (RG31) integral with a zone of the lower face of said element and extending between and at a distance from the two gate regions as far as the first gate dielectric,
**characterised in that** each gate region (RG1, RG2) protrudes from said continuous element (RG30) of said additional region (RG3), the structure further comprising, on either side of said additional region, two electrically conductive contact pads (CNL1, CNL2) respectively in contact with the two gate regions.

2. Structure according to claim 1, wherein the two gate regions (RG1, RG2) are aligned.

3. Structure according to one of the preceding claims, wherein the orthogonal projections onto the substrate of the two facing profiles (PRF1, PRF2) of the two gate regions are free from rounded portions.

4. Structure according to one of the preceding claims, wherein the second gate dielectric (012) comprises a layer of silicon nitride (OX120) sandwiched between two layers of silicon dioxide (OX121, OX122).

5. Structure according to one of the preceding claims, wherein the materials forming the two gate regions (RG1, RG2) and the additional region (RG3) include polysilicon.

6. Structure according to one of the preceding claims, further comprising an additional electrically conductive contact pad (CNL3) in contact with said additional region.

7. Memory device comprising a memory plane including rows and columns of memory cells (CEL_{i,j}) of the type including a unit memory cell of the SRAM type (CELSR) having two cross-coupled inverters and at least one non-volatile unit memory cell (CELNV) that are coupled to one another, and processing means (MTR) configured to manage the memory plane, **characterised in that** each of the non-volatile unit memory cells includes at least one floating-gate transistor (E1), and each unit memory cell of the SRAM type (CELSR) and/or the processing means (MTR) include at least one integrated structure (STR) according to one of claims 1 to 6.

8. Device according to claim 7, wherein each unit memory cell of the SRAM type has at least one integrated structure (STR), the two MOS transistors whereof respectively form the two PMOS transistors (P1, P2) of the two inverters.

9. Device according to claim 8, wherein said at least one integrated structure is a structure (STR) according to claim 6, wherein the additional contact pad (CNL3) is intended to be connected to a supply voltage (Vdd) or to the ground (GND).

10. Device according to claim 7, wherein the processing means (MTR) comprise a row decoder (DCDY) and a column decoder (DCDX) including integrated structures (STR) according to one of claims 1 to 6.

11. Device according to one of claims 7 to 10, wherein said at least one memory cell comprises a single non-volatile unit memory cell (E1) connected between a power supply terminal (BAL) and the unit memory cell of the SRAM type (CELSR), the floating-gate transistor (E1) of the non-volatile unit memory cell being capable of being controlled such that it is blocked when a datum stored in the unit memory cell of the SRAM type (CELSR) is being programmed in the non-volatile unit memory cell (E1).

12. Device according to one of claims 7 to 10, wherein said at least one memory cell comprises two groups (E1, E2) each including at least one non-volatile unit memory cell having a floating-gate transistor, all of the floating-gate transistors having the first conduction electrode thereof connected to a power supply terminal (BAL) and the control electrode thereof connected to a first control line (CGL), the second conduction electrodes of the floating-gate transistors of the non-volatile unit memory cells of the two groups being respectively connected to at least the outputs of the two inverters via a controllable interconnect stage (N2, N4, N5, N7), the floating-gate transistors (E1, E2) being capable of being controlled such that they can all be blocked when a datum stored in the unit memory cell of the SRAM type is being differentially programmed in the two groups of non-volatile unit memory cells.

13. Integrated circuit comprising a memory device according to one of claims 7 to 12.

14. Method for producing an integrated structure comprising a pair of neighbouring MOS transistors, the method comprising
a) forming a first gate dielectric (OX1) on top of a substrate (1),
b) forming a first layer of gate material (CHM1) on top of the first gate dielectric,
c) locally etching the first layer so as to form a rectangular slot (FNG) in said first layer extending in a first direction (DR1) between two ends,
d) forming a second gate dielectric (OX12) on the etched first layer and on the sidewalls of said slot,
e) forming a second layer of gate material (CHM2) on the second gate dielectric,
f) etching the second layer of gate material, the second dielectric, the first layer of gate material and the first dielectric, according to a profile (FNM2) having a rectilinear part overlapping said slot between the two ends thereof and extending in a second direction substantially orthogonal to the first direction, **characterised in that** it further comprises, after step f), locally etching the etched second layer of gate material and the etched second dielectric, so as to make each gate region of said continuous element (RG30) protrude from said additional region (RG3), and forming electrically conductive contact pads (CNL1, CNL2) on the two protruding parts of the two gate regions,
so as to form, for each of the two MOS transistors, a controllable gate region separated from an underlying substrate zone by the first gate dielectric and an additional region of gate material, separated from the two gate regions by the second gate dielectric, and having a continuous element located on top of a part of the two gate regions and a branch integral with a zone of the lower face of said element and extending between and at a distance from the two gate regions as far as the first gate dielectric.
